Europäisches Patentamt

European Patent Office

Office européen des brevets

(19)

(11) EP 0 893 739 A1

(12) EUROPÄISCHE PATENTANMELDUNG

(43) Veröffentlichungstag:
27.01.1999 Patentblatt 1999/04

(51) Int. Cl.⁶: G03F 7/30

(21) Anmeldenummer: 98113815.9

(22) Anmeldetag: 23.07.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 25.07.1997 DE 19732154

(71) Anmelder: BASF Drucksysteme GmbH
48165 Münster (DE)

(72) Erfinder:
• Stephan, Oskar
  68766 Hockenheim (DE)

• Schenk, Wolfgang, Dr.
  68723 Plankstadt (DE)
• Wegener, Stefan, Dr.
  55124 Mainz (DE)
• Thiele, Heino, Dr.
  67063 Ludwigshafen (DE)
• Weidmann, Albrecht
  77694 Kehl (DE)

(74) Vertreter:
Isenbruck, Günter, Dr.
Patent- und Rechtsanwälte Bardehle-
Pagenberg-Dost-Altenburg-Geissler-Isenbruck
Theodor-Heuss-Anlage 12
68165 Mannheim (DE)

(54) Verfahren und Vorrichtung zum Nachbehandeln wässriger Suspensionen, die beim Auswaschen belichteter lichtempfindlicher Druckplatten anfallen

(57) Es wird ein Verfahren zum Nachbehandeln wäßriger Suspensionen beschrieben, die insbesondere beim Entwickeln belichteter lichtempfindlicher Druckplatten anfallen, wobei man die in der Suspension enthaltenen Partikel durch rasche Bewegung dispergiert, indem man die Suspension zum Herstellen einer stabilen Dispersion durch eine Zone hohen Schergefälles führt, die erhaltene stabile Dispersion gegebenenfalls von nicht dispergierten Feststoffen abtrennt und einer üblichen Abwasserbehandlung zuführt.

EP 0 893 739 A1

**Beschreibung**

Die Erfindung betrifft ein Verfahren und eine Vorrichtung zum Nachbehandeln waßriger Auswaschlösungen, insbesondere von solchen, die beim Entwickeln von belichteten lichtempfindlichen, insbesondere photopolymerisierbaren Druckplatten, vor allem Reliefdruckplatten, anfallen und die suspendierte oder dispergierte Partikel enthalten.

Zur Verringerung der Umweltbelastung werden in neuerer Zeit Druckplatten, zum Beispiel solche auf Basis von photopolymerisierbaren Gemischen in der lichtempfindlichen Schicht, zunehmend mit wäßrigen Entwicklern, das heißt mit Wasser oder mit verdünnten wäßrig-alkalischen, wäßrig-sauren Lösungen oder wäßrigen Tensidlösungen, ausgewaschen. Derartige Platten und Auswaschlösungen sind zum Beispiel in den EP-A 0 223 114, 0 261 910, 0 430 233, 0 552 799 und 0 667 561 beschrieben.

Ein großes Problem ist dabei, daß die ausgewaschenen und gegebenenfalls neutralisierten Stoffe im allgemeinen nicht oder nur teilweise im Auswaschmedium löslich sind. Dies führt a) zu Ablagerungen und Verschmutzungen im Auswaschgerät, b) zu Belegungen und Verstopfungen der ableitenden Rohre und c) dazu, daß im allgemeinen die anfallenden Waschlaugen nicht in öffentliche Kläranlagen eingeleitet werden können. Es sind deshalb aufwendige Nachbehandlungen, beispielsweise Filtrieren oder Zentrifugieren der Waschlauge oder Ausfällen beziehungsweise Ausflocken der Feststoffe erforderlich, ehe man die Lauge in die Kläranlage einleiten kann.

In der EP-A 0 430 233 wird ein Auswaschverfahren für photopolymerisierbare Flexodruckplatten beschrieben, bei dem die ausgewaschenen Nichtbildbereiche nur teilweise in der Auswaschflüssigkeit, besonders Wasser, löslich sind. Hier wird die Auswaschlauge im Kreislauf geführt und dabei die dispergierte unlösliche Festsubstanz kontinuierlich durch Filtrieren aus dem Kreislauf genommen. Vor allem um eine Abscheidung oder Redeponierung von Festpartikeln auf der bereits entwickelten Reliefschicht zu verhindern, wird die Lösung mit hoher Fließgeschwindigkeit umgepumpt. Das kontinuierliche Abfiltrieren erfordert einen regelmäßigen Austausch und eine ständige Wartung der Filterbereiche, kann aber nicht verhindern, daß sich in Leitungen und Geräteteilen Abscheidungen und möglicherweise Verstopfungen bilden, insbesondere nach Stillstand des Geräts.

Ein ähnliches Entwicklungsverfahren ist in der WO 93/07539 beschrieben, bei dem Festbestandteile aus der verbrauchten Entwicklerlösung mittels eines Zentrifugalfilters abgetrennt werden.

Bei den meisten bekannten Verfahren ist es üblich, möglichst viel Festsubstanz durch Ausfällen oder Filtrieren aus der Auswaschlösung abzutrennen. Dabei fallen naturgemäß relativ große Mengen an Festsubstanz an, die entsorgt werden müssen.

Aufgabe der Erfindung war es, ein Nachbehandlungs- beziehungsweise Aufarbeitungsverfahren für Abwässer, insbesondere Auswaschlaugen, die beim Entwickeln von belichteten lichtempfindlichen Druckplatten anfallen, vorzuschlagen, bei dem die darin enthaltene organische Substanz möglichst weitgehend in einer Form anfällt, die ein Einleiten in allgemeine, zum Beispiel kommunale Abwasserkläranlagen erlaubt.

Die Erfindung geht aus von einem Verfahren zum Nachbehandeln wäßriger Suspensionen, insbesondere solchen, die beim Entwickeln belichteter lichtempfindlicher Druckplatten anfallen, wobei die in der Suspension enthaltenen Partikel durch rasche Bewegung dispergiert werden, die erhaltene stabile Dispersion gegebenenfalls von nicht dispergierten Feststoffen abgetrennt und einer üblichen Abwasserbehandlung zugeführt wird.

Das erfindungsgemäße Verfahren ist dadurch gekennzeichnet, daß man die Suspension zum Herstellen einer stabilen Dispersion durch eine Zone hohen Schergefälles führt.

Das Schergefälle $\kappa$ hat im allgemeinen einen Wert von $10^2$ bis $10^7$, vorzugsweise von $10^3$ bis $10^7$ s$^{-1}$. Es wird vorzugsweise dadurch erzeugt, daß die Suspension durch den Spalt zwischen einem Rotor und einem Stator hindurchgeführt wird, der im allgemeinen eine Weite von 0,01 bis 2,0, vorzugsweise von 0,01 bis 1 mm hat. Die Lösung wird unter hohem Druck durch den Mahlspalt gepreßt, so daß eine entsprechend hohe Scherspannung erreicht wird. Die Umfangsgeschwindigkeit des Rotors beträgt im allgemeinen 5 bis 60, bevorzugt 15 bis 60 m/s. Die maximale Fluidschubspannung $\tau_{max}$ ist im allgemeinen nicht größer als $10^7$ N/m$^2$.

Die Erfindung wird insbesondere in einer Vorrichtung verwirklicht, die einen Stator und einen an dessen Form derart angepaßten Rotor aufweist, daß bei Betätigung des Rotors ein enger Spalt zwischen Stator und Rotor gebildet wird. Die Suspension wird in geeigneter Weise, zum Beispiel durch eine in das Zentrum des Mahlspalts führende Leitung, in den Spalt eingeleitet und nach dem Passieren des Spalts, zum Beispiel an dessen Umfang, von diesen abgeführt.

Durch die Einwirkung hoher Scherkräfte auf die Waschlösungen wird es möglich, schlecht, unvollständig oder nicht gelöste Bestandteile in der Auswaschlösung stabil zu dispergieren und eines oder mehrere der bereits beschriebenen Probleme (Wascherverschmutzung, Verschmutzung der ableitenden Rohre, Nichteinleitbarkeit sowie schlechte Abbau- oder Eliminierbarkeit in Kläranlagen) zu vermeiden.

Ein Stoffgemisch, das aus einer flüssigen Phase und aus mindestens einer weiteren darin nicht oder nur teilweise löslichen flüssigen Phase besteht, wird als Emulsion bezeichnet.

Ein Stoffgemisch, das aus einer flüssigen Phase und aus mindestens einer darin nicht oder nur teilweise löslichen festen Phase besteht, wird als Suspension bezeichnet. Diese Stoffsysteme können zusammenfassend auch als Dispersionen bezeichnet werden.

Eine Dispersion besteht allgemein aus einer zusammenhängenden Phase (kontinuierliche Phase, zum Beispiel Flüssigkeit, speziell Wasser) und aus mindestens einer verteilten Phase (diskontinuierliche Phase, disperse Phase, zum Beispiel Flüssigkeit, Feststoff). Liegen in Zwei- oder Mehrstoffsystemen Teilchen der diskontinuierlichen Phase(n) mit Teilchengrößen unterhalb 0,2 μm mit hohem Verteilungsgrad vor, so werden diese Dispersionen als kolloide Dispersionen bezeichnet. Dispergieren kann nicht nur zur Vergrößerung der Oberfläche zwischen der kontinuierlichen und der dispersen Phase und damit zum besseren Stoffübergang (zum Beispiel bei der Emulsionspolymerisation) eingesetzt werden, sondern auch zur Stabilisierung und Homogenisierung, da die Trennzeit zweier nicht mischbarer Flüssigkeiten unterschiedlicher Dichte (oder von Flüssigkeit und Feststoff) von der Partikelgröße abhängt. Im allgemeinen liegen die Teilchengrößen bei diesem Prozess zwischen 0,5 μm und 100 μm, wobei auch kleinere Partikeldurchmesser erreichbar sind. Die Sedimentationsgeschwindigkeit wird durch das Stokes'sche Gesetz wiedergegeben:

$$V_s = \frac{d^2(\rho_P - \rho_{Fl})g}{18\eta}$$

$V_s =$     Sedimentationsgeschwindigkeit
$d =$     Partikeldurchmesser
$\eta =$     dynamische Viskosität der Flüssigkeit
$\rho_P =$     Partikeldichte
$\rho_{Fl} =$     Dichte der Flüssigkeit
$g =$     Erdbeschleunigung

Geeignet zur Dispergierung sind Geräte, die Schergefälle von $\kappa = 10^2 - 10^7$ s$^{-1}$, bevorzugt $10^3 - 10^7$ s$^{-1}$, erzeugen können. Solche Schergefälle können zum Beispiel durch a) Naßrotormühlen (Rotor-Stator-Systeme, zum Beispiel Scheibenrührer mit Stator, Ultra-Turrax®-Dispergiermaschinen, Stiltscheibendissolver, Zahnkolloidmühlen, Innenzahnradpumpen etc.) oder b) Dissolver-Systeme erreicht werden (siehe Tabelle 1).

Die Erzeugung des Schergefälles soll beispielhaft an den Naßrotormühlen erklärt werden. Es handelt sich dabei um schnelllaufende (Umfangsgeschwindigkeit $v_u = 5$ bis 60 m/s, vorzugsweise 15 bis 60 m/s) profilierte, mit Zähnen besetzte oder scheibenförmige Rotor-Stator-Systeme und Apparate, in denen die Auswaschlösung mit großem Druck durch enge Spalte gepreßt wird. Die Zerkleinerung erfolgt durch Scherspannung im Mahlspalt zwischen Rotor und Stator, wobei eine Variation der Feinheit und des Durchsatzes durch Veränderung des Mahlspaltes möglich ist. Die maximale Partikelgröße ist deshalb von der engsten Spaltbreite, die bis 0,01 mm betragen kann, abhängig. Sind die Partikeln oder Agglomerate kleiner als die Spaltbreite, so ist nur das Scherfeld der Flüssigkeit zwischen dem mit großer Drehzahl und großer Umfangsgeschwindigkeit $v_u$ drehenden Rotor und dem ruhenden Stator wirksam. Die folgende Tabelle 1 gibt Beispiele für handelsübliche Maschinen an.

## Tabelle 1

| Apparat | $V_u$ [m/s] | Spalt S [mm] | $\tau_{max}$ [N/m²] | $\eta$ [mPas] | $\kappa_{max}$ [s⁻¹] |
|---|---|---|---|---|---|
| Intensiv-Mischer | 5,6-8,5 | 0,2-0,5 | $10^7$ | $5 \times 10^5$ | $< 10^5$ |
| Dissolver/ Disperser | $< 35$ | - | $< 10^3$ | $10^2$-$10^3$ | $10^2$-$10^3$ |
| Naßrotor-mühlen: | | | | | |
| Innenzahn-radpumpe(Viking) | 6,0 | 0,11 | $< 10^4$ | $10^3$ | $6 \times 10^3$ |
| Ultra-Tur-rax-Dispergiermasch. | 25 | 0,01 | $< 10^6$ | " | $10^6$ |
| Korundsch-Mühlen | 25,1-56,5 | 0,01 | $< 10^7$ | " | $2,5$-$5,6 \times 10^6$ |
| Kolloid-Mühlen | 15,7-39,3 | 0,05 | $< 10^6$ | " | $0,3$-$0,78 \times 10^6$ |
| Gorator Schrägscheibe | 25,3-32,0 | 0,75 | $< 10^5$ | " | $33$-$43 \times 10^3$ |
| Siefer SM 180 | 50,8 | 0,05 | $< 10^6$ | " | $10^6$ |
| Supraton 200 | 51 | 0,05 | $< 10^6$ | " | $10^6$ |
| PUC 60 | 0,4 | 0,04 | $< 10^6$ | " | $0,23 \times 10^6$ |

Die Aggregate zur Dispergierung und Homogenisierung der Auswaschlösungen werden zweckmäßigerweise als kontinuierliche Förderpumpe eingesetzt, jedoch ist auch eine zusätzliche kontinuierliche oder diskontinuierliche in-line- oder off-line-Zuschaltung solcher Dispergiergeräte möglich.

Saure oder alkalische Auswaschlösungen photopolymerisierbarer Druckplatten sind aufgrund ihres pH-Wertes nicht in das öffentliche Abwassersystem einleitbar. Bei der Neutralisation dieser Waschlösungen kommt es im allgemeinen zum Ausfallen von Feststoffen, die abfiltriert werden müssen. Wenn eine Auswaschlösung neutralisiert werden muß, kann das Dispergiergerät auch nur für den Neutralisationsschritt im Wascher oder nach Abpumpen in ein separates Gefäß zugeschaltet werden, um so ausfallende Partikel direkt wieder zu dispergieren. Dies gilt ebenfalls für den Fall, daß der Dispergierschritt nur zur Verbesserung der Einleitbarkeit in öffentliche Kläranlagen angewendet wird.

Durch die Scherbehandlung wird die Beständigkeit der Homogenität der Waschlauge für die Einleitung in das öffentliche Abwassersystem gewährleistet und die Abbaubarkeit kolloider und disperser organischer Inhaltsstoffe in öffentlichen biologischen Kläranlagen verbessert. (Beispiele 3 und 4).

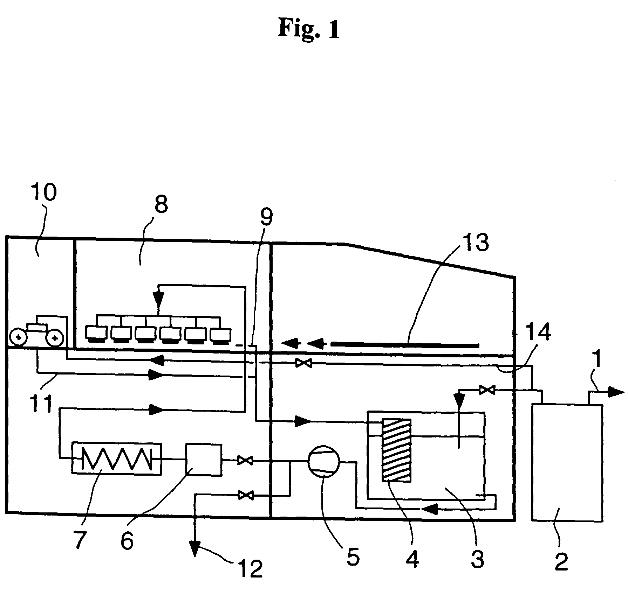

In der Zeichnung (Figur 1) ist eine Druckplatten-Auswaschvorrichtung, wie sie bei dem erfindungsgemäßen Verfahren eingesetzt wird, schematisch dargestellt. Mit 1 ist der Zulauf für Frischwasser, mit 2 eine gegebenenfalls erforderliche Enthärterstation bezeichnet. Aus dieser wird das Wasser in den Vorratstank 3 geleitet, in den bei 4 auch die anfallende Auswaschlauge zurückgeführt wird. Mit 5 ist die als Förderpumpe eingesetzte Dispergiermaschine bezeichnet, in der der Flüssigkeitsstrom eine Zone hohen Schergefälles passiert und dann weiter über das Feststoffmeßgerät 6 und durch einen Durchlauferhitzer 7 in die Bürstenauswaschzone 8 gelangt. Dort wirkt sie zum Auswaschen der Nichtbildbereiche der belichteten lichtempfindlichen Schicht der Druckplatte 13 auf diese ein und wird über eine Leitung bei 4 wieder in den Vortatstank 3 zurückgeführt. Die Druckplatte 13 wird weiter durch die Nachspülzone 10 geführt, in der sie mit frischem Wasser nachbehandelt wird, das durch die Zweigleitung 14 direkt aus der Enthärterstation 2 zugeführt wird. Das verbrauchte Wasser wird durch eine Rücklaufleitung 11 über 4 in den Vorratstank 3 zurückgeführt. Im kontinuierlichen Betrieb wird zur Einhaltung einer vorgegebenen Konzentration an organischer Substanz ein Teil der Lösung nach dem Passieren der Dispergiermaschine über eine Ableitung 12 aus dem Kreislauf genommen und in das Abwasser geleitet.

## BEISPIELE

### Beispiel 1

Eine handelsübliche wasserentwickelbare Flexodruckplatte der BASF (nyloaqua® FW) von 2,84 mm Dicke auf Basis eines Ethylen-Acrylsäure-Acrylester-Terpolymeren wurde 50 Sekunden mit UV-Licht der Wellenlänge 366 nm (80W-Röhren) rückseitig ohne Vorlage vorbelichtet und anschließend 8 Minuten bildmäßig von der Vorderseite her hauptbelichtet. Die Platte wurde in einem für den Betrieb mit Wasser umgerüsteten Durchlaulwascher für Flexodruckplatten (BASF Combi LF II) entwickelt. Das Gerät enthielt anstelle der standardmäßigen Pumpe eine Ultra-Turrax®-Dispergiermaschine (Fa. JKA, Jahnke u. Kunkel GmbH, Modell UTL-T60/4P) als kontinuierliche Förderpumpe. Mit dem Ultra-Turrax-Dispergiergerät wird die Waschlauge einem Schergefälle von ca. $\kappa = 10^6\ s^{-1}$ ausgesetzt. Die Umfangsgeschwindigkeit des Rotors beträgt ca. 25 m/s, die Spaltweite zum Stator 0,01 mm. Die resultierende Waschlauge, die 1,6% organische Substanz enthielt, war homogen, zeigte kein Aufrahmen (Abscheidung von Substanz an der Oberfläche) im Vorratstank, und im Wascher beobachtete man, auch bei Dauergebrauch, keine Belegungen. Diese Waschlauge kann deshalb in das öffentliche Abwassersystem eingeleitet werden.

### Beispiel 2 (Vergleichsbeispiel)

Es wurde wie in Beispiel 1 gearbeitet, jedoch wurde der Wascher mit einer Kolbenpumpe als Förderpumpe betrieben. Beim Stehen der Waschlauge im Tank wurde ein Aufrahmen der Dispersion beobachtet, was zu Verklebungen an der Tankwand und der Füllstandsanzeige führte. Darüber hinaus wurden Belegungen in den Einleitungsrohren zu den Bürsten und in Rohrabschnitten mit großem Innendurchmesser gefunden, die einen Dauergebrauch unmöglich machten. Vor der Einleitung der Waschlauge in das öffentliche Abwassersystem mußte deshalb die Waschlauge nachbehandelt werden, um Beeinträchtigungen des Kanalbetriebs auszuschließen.

### Beispiel 3

Die 3% organische Stoffe enthaltende Waschlauge einer in Wasser entwickelten Akzidenz-Reliefdruckplatte auf Polyvinylalkoholbasis (BASF nyloprint® WFH 95) wurde mit einem Euroturrax®-Dispergierer (JKA, Modell T 20b), der zur Erzeugung hoher Schergefälle geeignet ist, 2 Minuten bei 27000 U/min nachbehandelt. Die TOC-Elimination, das heißt die Abnahme des TOC-Gehalts (TOC = total organic carbon), im statischen Test, vor allem in der Anfangsphase, wurde deutlich gesteigert. Der Test wurde so durchgeführt, daß eine Probe der angefallenen Waschlauge 2 Minuten mit dem Dispergiergerät behandelt wurde und eine andere, gleiche Probe zum Vergleich unbehandelt blieb. Beide Dispersionen wurden über ein Weißbandfilter (white ribbon) der Firma Schleicher & Schüll, Referenz Nr. 300 110, aschefrei, Durchmesser 110 mm, Porenweite 5 bis 6 μm, filtriert und das Filtrat mit 4 g/l an Belebtschlammtrockensubstanz versetzt. Der Restgehalt an gesamtem organischem Kohlenstoff in Lösung in mg/l (TOC') wurde zu Beginn und in den angegebenen zeitlichen Abständen während des biologischen Abbaus bestimmt (Zahn/Wellens-Test, ISO 9888). Die Ergebnisse zeigt Tabelle 2, Spalte 2. In einer weiteren Spalte ist dann die zum jeweiligen Zeitpunkt erreichte Reduktion (Elimination) an organischer Substanz in Prozent der ursprünglich in der Waschlauge enthaltenen Menge angegeben.

## Tabelle 2

| Zeit | ohne Scherung | | nach Behandlung im Dispergierer | |
| --- | --- | --- | --- | --- |
| | TOC' | Elimination | TOC' | Elimination |
| 0 | 448 | - | 458 | - |
| 3 h | 355 | 20,7% | 323 | 29,5% |
| 1 Tag | 312 | 30,4% | 234 | 48,9% |
| 2 Tage | 272 | 39,3% | 198 | 56,8% |
| 4 Tage | 262 | 41,5% | 182 | 60,3% |
| 5 Tage | 255 | 43,1% | 173 | 62,2% |
| 7 Tage | 207 | 53,8% | 169 | 63,1% |
| 9 Tage | 163 | 63,6% | 129 | 71,8% |
| 12 Tage | 88 | 80,4% | 65 | 85,7% |
| 14 Tage | 80 | 82,1% | 61 | 86,6% |
| 16 Tage | 68 | 84,8% | 65 | 85,9% |
| 19 Tage | 67 | 85,0% | 57 | 87,6% |
| 22 Tage | 81 | 81,9% | 57 | 87,6% |
| 27 Tage | 91 | 79,7% | 52 | 88,6% |
| 28 Tage | 61 | 86,4% | 49 | 89,3% |

TOC' = Gesamter organischer Kohlenstoff (mg/l) nach Filtration

**Beispiel 4**

Eine wasserentwickelbare Flexodruckplatte des in Beispiel 1 angegebenen Typs wurde wie in Beispiel 1 beschrieben belichtet. Die Platte wurde in dem in Figur 1 dargestellten Auswaschgerät entwickelt. Das Gerät enthielt anstelle der standardmäßigen Pumpe die in Beispiel 1 bezeichnete Dispergiermaschiene als kontinuierliche Förderpumpe. Mit dieser Maschine wurde die 1,6%ige Waschlauge einem Schergefälle von ca. $\kappa = 10^6$ s$^{-1}$ ausgesetzt. Die Umfangsgeschwindigkeit des Rotors betrug ca. 25 m/s, die Spaltweite zum Stator 0,01 mm. Es konnten lediglich 28% der homogen dispergierten organischen Stoffe durch Filtration über Weißbandfilter abgetrennt werden (TOC-Abnahme). Die restliche Waschlauge wurde einer abwassertechnischen Untersuchung unterworfen. Bereits nach 3 Tagen wurde im statischen Test eine TOC-Gesamtelimination von 95,3% erzielt (Tabelle 3).

## Tabelle 3

| Zeit | TOC', mg/l | Elimination TOC' | Gesamtelimination TOC |
|------|-----------|------------------|----------------------|
| 0 | 101,6 | 0% | 28,0% |
| 3 h | 11,3 | 88,9% | 91,9% |
| 1 Tag | 14,7 | 85,5% | 89,6% |
| 2 Tage | 13,7 | 86,5% | 90,3% |
| 3 Tage | 6,7 | 93,4% | 95,3% |
| 6 Tage | 4,3 | 95,8% | 96,9% |
| 8 Tage | 3,3 | 96,8% | 97,7% |

**Beispiel 5 (Vergleichsbeispiel)**

Eine in Wasser entwickelbare Flexodruckplatte vom Typ nyloaqua® FW auf Basis eines Ethylen/Acrylsäure/Ethylhexylacrylat-Terpolymeren wurde in einem Trommelwascher (Typ BASF F II-Bürstentrommelwascher) entwickelt, der eine konventionelle Förderpumpe enthält. Es fiel eine 2,1%ige Waschlauge mit teilweise abgeschiedenen Feststoffen an. Daraus konnten etwa 60% der organischen Feststoffe über ein Weißbandfilter abgetrennt werden. Die restliche Waschlauge wurde einer abwassertechnischen Untersuchung unterworfen. Die Restlösung zeigte im statischen Test erst nach 20 Tagen eine der gescherten Gesamtlösung entsprechende TOC-Gesamtelimination von 94,2% (Tabelle 4). Die Scherung führt also nicht nur zu einer verbesserten Eliminierbarkeit der organischen Inhaltsstoffe, es entfällt auch weitgehend die separate Entsorgung des abfiltrierten Feststoffanteils.

## Tabelle 4

| Zeit (Tage) | TOC' | Elimination TOC' | Gesamtelimination TOC |
|-------------|------|------------------|----------------------|
| 0 | 214 | 0% | 58,7% |
| 10 | 205 | 4,2% | 60,4% |
| 15 | 88 | 58,9% | 83,0% |
| 17 | 42 | 80,4% | 91,9% |
| 20 | 30 | 85,9% | 94,2% |

**Beispiel 6**

Die auf einem Ethylen/Acrylsäure/Acrylsäureester-Terpolymeren basierende Lackplatte nylocoat® LW, wurde 8 Minuten durch ein Negativ in einem Flachbelichter mit UV-Licht bestrahlt und in einem Auswaschgerät vom Typ BASF DW 135L mit 1 %iger Natronlauge entwickelt. Da die Waschlauge einen pH von 12 aufweist, darf sie nicht in öffentliche Kläranlagen eingeleitet sondern muß vorher neutralisiert werden (Anforderung im allgemeinen pH 6,5 bis 9,5). Dies geschieht normalerweise kurz vor dem Einleiten durch Neutralisieren der Gesamtlösung.

3 Liter der 3,7%igen Waschlauge mit 64% Polymeranteil im Feststoff wurden innerhalb 5 Minuten in einem 5-Liter-Becherglas mit 20%iger Salzsäure mittels eines Ultra-Turrax[6]-Dispergiergeräts vom Typ T 45/N mit Rotor-Stator G 45K bei 10000 U/min auf pH 8,6 eingestellt. Die Salzsäure wurde dabei direkt in die Scherzone dosiert. Im Verlauf der Neutralisation entstand starker Schaum. Nach Absetzen des Schaums resultierte eine über 4 Wochen stabile, extrem feinteilige Dispersion mit 1,85g Koagulat an der Oberfläche, entsprechend 2% des organischen Stoffanteils der Waschlauge. Koagulat entstand praktisch nur in der Schaumzone. Es läßt sich problemlos abrakeln oder kann durch nachfolgende Scherbehandlung ebenfalls stabil dispergiert werden. Der statische Abbautest nach Zahn-Wellens erbrachte hohe Eliminierungsraten (Tabelle 5).

## Tabelle 5

| Zeit | TOC'(mg/l) | Elimination TOC' | Gesamtelimination TOC |
|---|---|---|---|
| 0 | 95 | - | 52,5% |
| 3 h | 89 | 6,0% | 55,5% |
| 1 Tag | 73 | 23,2% | 63,5% |
| 3 Tage | 18 | 81,1% | 91,0% |
| 6 Tage | 15 | 84,2% | 92,5% |
| 8 Tage | 15 | 84,2% | 92,5% |
| 10 Tage | 4 | 95,9% | 98,0% |

**Beispiel 7 (Vergleichsbeispiel)**

Führt man die Neutralisation nicht unter der Einwirkung hoher Scherkräfte durch, kommt es bei der Neutralisation zur Koagulation der Bindemitteldispersion, und der ausgefallene Feststoff muß abfiltriert beziehungsweise anderweitig abgetrennt werden. Die Neutralisation kann dann nicht im Auswaschgerät durchgeführt werden und der Feststoff muß separat entsorgt werden. Die Scherungsneutralisation ermöglicht somit einen wesentlich vereinfachten Entsorgungsablauf.

**Beispiel 8**

Ein Combi LF II-Flexodruckplattenwascher wurde für den Betrieb mit Wasser umgerüstet. Die vorhandene Umwälzpumpe wurde durch eine in-line-Ultra-Turrax®-Dispergiermaschine (UTL-150-Ph, Fa. JKA, eingesetzte Umwälzleistung ca. 2 m³/h) ersetzt, die über Magnetventilsteuerung auch als Austragspumpe benutzt wurde. Das Gerät zeigte keine Belegungen (wie in Beispiel I) und die Waschlauge zeigte im statischen Test stark verbesserte TOC-Gesamtelimination (vergleiche Beispiel 4).

**Patentansprüche**

1. Verfahren zum Nachbehandeln wäßriger Suspensionen, die insbesondere beim Entwickeln belichteter lichtempfindlicher Druckplatten anfallen, wobei die in der Suspension enthaltenen Partikel durch rasche Bewegung dispergiert werden, die erhaltene stabile Dispersion gegebenenfalls von nicht dispergierten Feststoffen abgetrennt und einer üblichen Abwasserbehandlung zugeführt wird, dadurch gekennzeichnet, daß man die Suspension zum Herstellen einer stabilen Dispersion durch eine Zone hohen Schergefälles führt.

2. Verfahren nach Anspruch 1, dadurch gekennzeichnet, däß das Schergefälle $\kappa = 10^2$ bis $10^7$ $s^{-1}$ beträgt.

3. Verfahren nach Anspruch 1, dadurch gekennzeichnet, daß zur Erzeugung des Schergefälles ein Rotor in geringem Abstand von einem Stator bewegt wird und daß die Suspension durch den Spalt zwischen Rotor und Stator zwangsgeführt wird.

4. Verfahren nach Anspruch 3, dadurch gekennzeichnet; daß der Spalt eine Weite von 0,01 bis 2,0 mm hat.

5. Verfahren nach Anspruch 3, dadurch gekennzeichnet, daß die Umfangsgeschwindigkeit des Rotors $v_u$ 5 bis 60 m/s beträgt.

6. Verfahren nach Anspruch 1 oder 3, dadurch gekennzeichnet, daß die maximale Fluidschubspannung $\tau_{max}$ nicht

größer als $10^7$ N/m$^2$ ist.

7. Verfahren nach Anspruch 1, dadurch gekennzeichnet, daß die wäßrige Suspension vor oder während der Scherbehandlung neutralisiert wird.

8. Vorrichtung zum Nachbehandeln wäßriger Suspensionen, die beim Entwickeln belichteter lichtempfindlicher Druckplatten anfallen, mit einem Stator und einem an diesen derart angepaßten Rotor, daß bei Betätigung des Rotors ein enger Spalt zwischen Stator und Rotor gebildet wird, Mitteln zum Einführen der Suspension in den Spalt und Mitteln, um die Suspension aus dem Spalt abzuführen, nachdem sie diesen passiert hat.

9. Vorrichtung nach Anspruch 8, dadurch gekennzeichnet, daß der Spalt eine Weite von 0,01 bis 2,0 mm hat.

10. Vorrichtung nach Anspruch 8, dadurch gekennzeichnet, daß sie zur Erzeugung eines Schergefälles im Spalt zwischen Rotor und Stator von $\kappa = 10^2$ bis $10^7$ s$^{-1}$ geeignet ist.

# Fig. 1

EP 0 893 739 A1

| Europäisches Patentamt | EUROPÄISCHER RECHERCHENBERICHT | Nummer der Anmeldung EP 98 11 3815 |

**EINSCHLÄGIGE DOKUMENTE**

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| D,A | EP 0 430 233 A (TOYO BOSEKI) 5. Juni 1991 --- | | G03F7/30 |
| A | WO 95 24257 A (ATOTECH USA INC ;BARON DAVID T (GB); TAYLOR ALEXANDER R (GB); JOHA) 14. September 1995 ----- | | |
| | | | **RECHERCHIERTE SACHGEBIETE (Int.Cl.6)** G03F C02F |

Der vorliegende Recherchenbericht wurde für alle Patentansprüche erstellt

| Recherchenort | Abschlußdatum der Recherche | Prüfer |
|---|---|---|
| DEN HAAG | 17. November 1998 | Haenisch, U |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)